# EUROPEAN PATENT SPECIFICATION

(11) **EP 2 696 507 B1**
(45) Date of publication and mention of the grant of the patent: **25.10.2017**
(21) Application number: 12005740.1
(22) Date of filing: 08.08.2012
(51) Int. Cl.: H04B 1/04

(54) **A method for improving signal accuracy of a transmitted or a received signal**
Verfahren zur Verbesserung der Signalgenauigkeit eines übertragenen oder empfangenen Signals
Procédé permettant d'améliorer la précision d'un signal transmis ou d'un signal reçu

(43) Date of publication of application: 12.02.2014
(73) Proprietor: Airbus Defence and Space GmbH, 82024 Taufkirchen (DE)
(72) Inventor: Floch, Jean-Jacques, 81677 München (DE)
(74) Representative: Frenkel, Matthias Alexander

(56) References cited:
- US-A1- 2006 067 426

## Description

The invention relates to a method for improving signal accuracy of a transmitted signal to be transmitted by a transmitter. Furthermore, the invention relates to a method for improving signal accuracy of a received signal to be received by a receiver. Moreover, the invention relates to a transmitter and a receiver as well as a computer program product.

In the field of telecommunication or navigation, a transmitter or receiver needs to transmit or to receive a signal with a minimum of distortions to be able to obtain high accuracy services. However, as soon as analog components, such as a band pass filter, are involved in a chain of components, it introduces distortions inside a useful bandwidth of the transceiver or receiver. To minimize distortions the components are often selected. However, some of them inside the useful still remain.

US 2006/0067426 discloses the generation of a multicarrier signal by pre-compensating frequency-domain subcarrier symbols for substantially linear distortion subsequently introduced by a time-domain baseband filter.

It is therefore an object of the present invention to provide a method which improves the signal accuracy of a transmitted or a received signal such that an equalization of the transmitted or the received signal is more accurate to compensate the distortion in the transmitter or receiver. It is a further object of the invention to provide a corresponding transmitter and receiver, respectively.

This object is solved by methods according to claim 1 and 2, a computer program product according to claim 12, a transmitter according to claim 13, and a receiver according to claim 14. Preferred embodiments are set out in the dependent claims. The invention is defined in the claims. According to the first aspect of the invention, a method for improving signal accuracy of a transmitted signal to be transmitted by a receiver is suggested. The transmitter comprises a signal improving unit having a pre-distortion filter before passing a chain of components having analog components of the transmitter. The method comprises the steps of evaluating a first transfer function of the amplitude and/or phase of the chain of components which has to be passed by the transmitted signal for a first bandwidth being broader then a useful transmitted bandwidth. Next, the transfer function is interpolated resulting in a modified first transfer function by multiplying a digital sampling frequency rate of the transmitted signal with an oversampling factor and extending the first transfer function artificially with zeros until an edge of the first bandwidth. Next, the zeros of the modified first transfer function are replaced by a lowest absolute value to avoid any NaN, Not a Number, values by inversing the transfer function. Last, first filter coefficients of the pre-distortion filter of the signal improving unit are evaluated for equalizing the transmitted signal.

In a second aspect, the invention suggests a method for improving signal accuracy of a received signal to be received by a receiver, wherein the receiver comprises a signal improving unit having a post-distortion filter after having passed a chain of components having analog components of the receiver. The method comprises the steps of evaluating a second transfer function of the amplitude and/or phase of the chain of components which has to be passed by a received signal for a second bandwidth being broader than the useful received bandwidth. Next, the second transfer function is interpolated resulting in a modified second transfer function by multiplying a digital sampling frequency rate of the received signal with an oversampling factor and extending the second transfer function artificially with zeros until an edge of the first bandwidth. As a next step, the zeros of the modified second transfer function are replaced by a lowest absolute value to avoid any NaN, Not a Number, values by inversing the transfer function. Last, second filter coefficients of the post-distortion filter of the signal improving unit are evaluated for equalizing the received signal.

The proposed method uses a pre- or post-distortion filter to equalize the signal transmitted or received by the transmitter or receiver, respectively. By applying the aforementioned algorithm, a very accurate equalization for the transmitted and received signal can be achieved. It is to be noted that the first and the second transfer function has to be evaluated of the complete chain of components, including the antenna of the receiver or transmitter. For evaluating a transfer function, two main known techniques exist. On the one hand, the transfer function can be evaluated by the help of a spectrum analyzer. On the other hand, a chirp signal may be used. The chirp signal method which is in principle known to a person skilled in the art is preferable as the signal passes through all analog components and digital-analog converters or analog-digital converters without using any external components.

In a preferred embodiment, the first bandwidth and the second bandwidth, respectively, are twice wider than the useful transmitted bandwidth and the useful received bandwidth.

According to a further preferred embodiment, equalization of the transmitted or the received signal is made at a baseband with an intermediate frequency f_{IF} = 0. However, the method can also be applied at any intermediate frequency. The advantage of this method is to generate zero's padding which will increase the performance of the pre- or post-distortion filter which may be realized as a FIR (Finite Impulse Response) filter or an IIR (Infinite Impulse Response) filter. All zeros of the interpolated transfer function are then replaced by the lowest absolute value. This process is done to avoid any NaN (Not a Number) values by inversing the transfer function.

For evaluating the first and the second filter coefficients, respectively, the Gauss Newton Algorithm is applied with which equalization is optimized for the useful transmitted or received bandwidth plus a margin bandwidth. Generally, the coefficients of the FIR or IIR may be evaluated by any algorithm which can solve design problems with simultaneous magnitude and phase approximation. The margin bandwidth may be equivalent to minimum 5 % of the useful bandwidth, for example.

Preferably, the phase of the inverse at a center frequency of the useful bandwidth is evaluated which is used as an input of the Gauss Newton Algorithm. Hence, the algorithm is able to converge. It is also preferred to decimate the first or second transfer function in order to limit the noise measurement error on the evaluation of the transfer function.

The number of the filter coefficients should be kept low to avoid ripples due to many stages. It is also preferable that the pre- or post-distortion filter does not follow the dynamic of the transfer function noise error.

In a further preferred embodiment, the first and second filter coefficients, respectively, are evaluated for a digital sampling rate of the oversampling factor multiplied by the digital sampling frequency f_{S} of the signal to be transmitted or received.

In a further preferred embodiment the digital transmitted signal (Digital) which is to be transmitted by the transmitter is interpolated by a factor K before being computed in the pre-distortion filter. Correspondingly, the digital received signal (Digital) received by the receiver is interpolated after an analog-digital conversion before being computed in the post-distortion filter.

The output of the pre- or post-distortion filter of the signal improving unit is filtered with a band pass filter at the useful bandwidth to suppress a potential distortion due to the pre- or post-distortion filter.

If a beam-forming is applied to the transmitter or to the receiver, each signal chain will be equalized independently.

The invention further suggests a computer program product directly loadable into the internal memory of a digital computer, comprising software code portions for performing the steps of the above-mentioned method when said product is run on a computer. The computer may be part of the transmitter or receiver.

Furthermore, the invention suggests a transmitter which comprises a signal improving unit having a pre-distortion filter before passing a chain of components having analog components wherein the chain of components has a known first transfer function of the amplitude and/or phase of a transmitted signal which passes the chain of components for a first bandwidth being broader than a useful transmitted bandwidth. The transmitter comprises
a) a first means for interpolating the first transfer function resulting in a modified first transfer function by multiplying a digital sampling frequency rate of the transmitted signal with an oversampling factor and extending the first transfer function artificially with zeros until an edge of the first bandwidth;
b) a second means for replacing the zeros of the modified first transfer function by a lowest absolute value to avoid any NaN, Not a Number, values by inversing the transfer function; and
c) a third means for evaluating first filter coefficients of the post-distortion filter of the signal improving unit for equalizing the transmitted signal.

Furthermore, the invention suggest a receiver comprising a signal improving unit having a post-distortion filter after having passed a chain of components having analog components wherein the chain of components has a known second transfer function of the amplitude and/or phase of a received signal which passes the chain of components for a second bandwidth being broader than a useful received bandwidth. The receiver comprises
a) a first means for interpolating the second transfer function resulting in a modified second transfer function by multiplying a digital sampling frequency rate of the received signal with an oversampling factor and extending the second transfer function artificially with zeros until an edge of the first bandwidth;
b) a second means for replacing the zeros of the modified second transfer function by a lowest absolute value to avoid any NaN, Not a Number, values by inversing the transfer function; and
c) a third means for evaluating second filter coefficients of the post-distortion filter of the signal improving unit for equalizing the received signal.

The invention will be explained in more detail with reference to the accompanying figures.
- Fig. 1: shows a transmitter according to the invention.
- Fig. 2: shows a receiver according to the invention.
- Figs. 3a to 3d: show first to fourth group delay chains in relation to a sampling frequency.
- Fig. 4a to 4d: shows first to fourth diagrams illustrating a scurve bias evaluation depending from a delay.

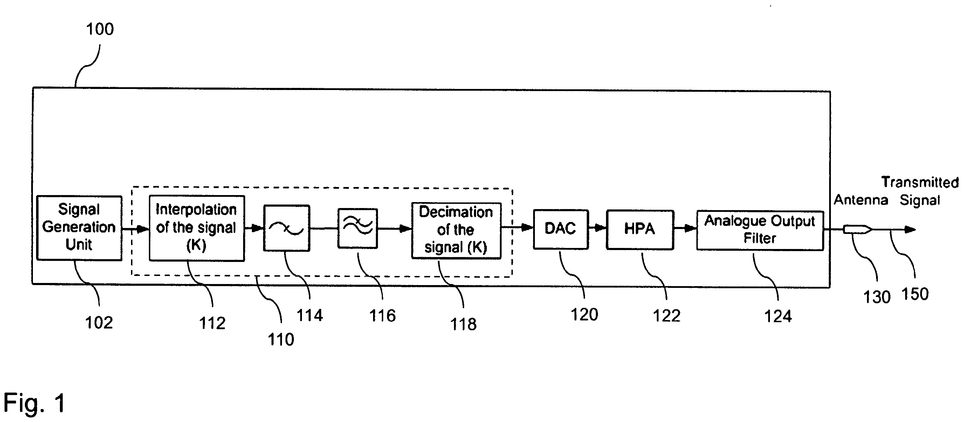

Fig. 1 shows a signal chain of a transmitter 100 according to the invention. The transmitter 100 comprises a signal improving unit 110 which is coupled to an output of a signal generation unit 102. An output of the signal improving unit 110 is coupled with a digital-analog converter (DAC) 120 which is followed by a high power amplifier (HPA) 122. An output of the high power amplifier 122 is connected to an analog output filter 124 which is coupled to an antenna 130 for transmitting a signal (transmitted signal) 150. DAC 120, HPA 122, analog output filter 124 and antenna 130 constitute a chain of components of the transmitter.

The signal improving unit 110 comprises an interpolation stage 112, a pre-distortion filter 114 realized as a FIR (Finite Impulse Response) or IIR (Infinite Impulse Response) filter, a digital band-pass filter 116 defining a useful bandwidth and a decimation stage 118. The function of the signal improving unit will be described below.

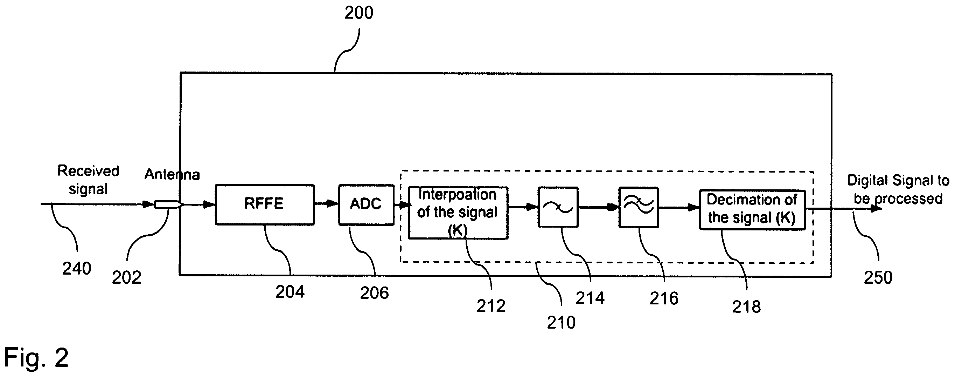

Fig. 2 shows a signal chain of a receiver according to the invention. The received signal 240 is received by an antenna 202 of the receiver 200. The antenna 202 is connected to an analog RF (Radio Frequency) front-end (RFFE) 204. An output of the RFFE 204 is connected to an analog-digital converter (ADC) 206. The ADC is connected to a signal improving unit 210 which comprises the same components as already noted in connection with the signal improving unit 110 of the transmitter 100. Hence, the signal improving unit 210 comprises an interpolation stage 212, a post-distortion filter 214 being realized as FIR or IIR filter, a digital band-pass filter 216 defining a useful bandwidth and a decimation stage 218. An output of the signal improving unit 210 outputs a digital signal 250 to be processed later on. The antenna 202, the RFFE 204 and the ADC 206 constitute a chain of components of the receiver.

Generally, analog components of the transmitter 100 and the receiver 200 such as an output filter or DAC in case of the transmitter and a RFFE, LNA or ADC in case of the receiver may cause distortion on the signal phase which causes group delay.

To minimize the group delay, an accurate equalization is proposed to compensate for the distortion in the transmitter or receiver chains. It is to be understood that in case of beam-forming to the transmitter or the receiver 100, 200, each signal chain as outlined in Figs. 1 and 2 has to be equalized independently.

The proposed method is as follows:
First, the transfer function of the amplitude and/or phase of the complete chain of components including the antenna has to be evaluated. In case of the transmitter the chain of components comprises the DAC 120, the HPA 122, the analog output filter 124 and the antenna 130. In case of the receiver 200 the chain of components comprises the antenna 202, RFFE 204 and ADC 206. Two main known technologies exist to evaluate the transfer function. One possibility is to use a spectrum analyzer, another to use a chirp signal. The chirp signal method is preferable as the transmitted or received signal passes through the analog components and the DAC or ADC without using any external components. The transfer function is evaluated for a bandwidth twice wider than the useful transmitted for received bandwidth.

The transfer function is then interpolated considering the digital sampling frequency rate f_{S} of the transmitted or received signal 150, 240 multiplied by an oversampling factor K. The transfer function is then artificially extended with zeros until the edge of the bandwidth according to f_{IF} ± K × f_{S}/2. It is considered to equalize at the baseband with an intermediate frequency f_{IF} = 0. However, the method can also be applied at any intermediate frequency.

The advantage of this procedure is to generate zero padding which will increase the performance of an FIR or IIR equalization algorithm. All the zeros of the interpolated transfer function are then replaced by a lowest absolute value. This process may be done to avoid any NaN values by inversing the transfer function.

In a next step, FIR or IIR coefficients (in general filter coefficients) are evaluated by an algorithm which can solve design problems where simultaneous magnitude and phase approximation are desired. For example, the well-known Gauss Newton Algorithm may be applied, but any performing algorithm may be used. The equalization is optimized for the useful bandwidth plus a margin bandwidth, for example equivalent to minimum 5 % of the bandwidth.

For the convergence of the algorithm it is preferred to evaluate the phase of the inverse at the center frequency of the useful bandwidth and to use it as an input of the algorithm. It is also preferred to decimate the transfer function with help of the decimation stage 118 and 218 in order to limit the noise measurement error on the evaluation of the transfer function.

It is preferred that the number of FIR or IIR coefficients is low to avoid ripples due to many stages. It is also important that the FIR or IIR filter does not follow the dynamic of the transfer function noise error.

The FIR or IIR filter coefficients are evaluated for a digital sampling rate of K × f_{S}. The digital signal is interpolated by a factor K in the interpolation stage 112 after its generation in the signal generation unit 102. Accordingly, the digital signal is interpolated by a factor of K in the interpolation stage 212 after the analog-digital conversion in the ADC 206 of the receiver 200. The band-pass filter 116, 216 which follows the FIR or IIR filter stage 114, 214 is used to suppress the potential distortion due to the FIR or IIR filter 114, 214.

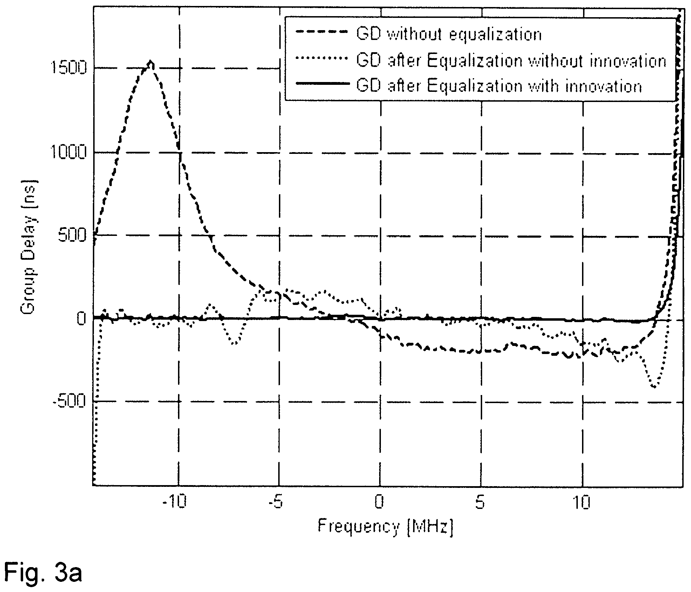

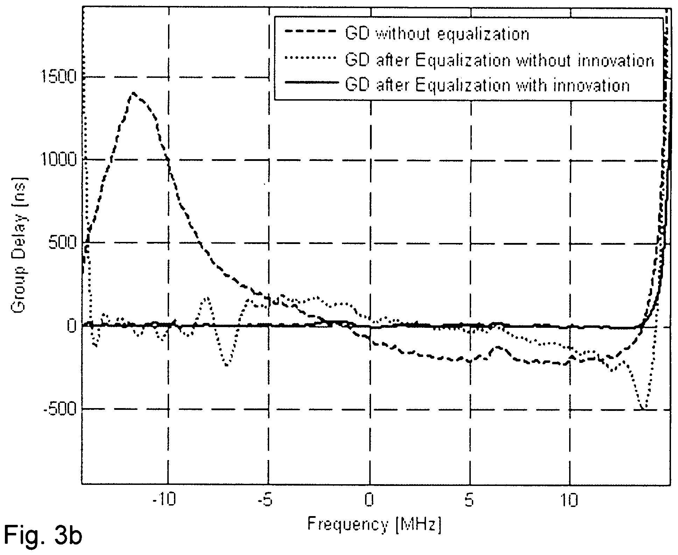

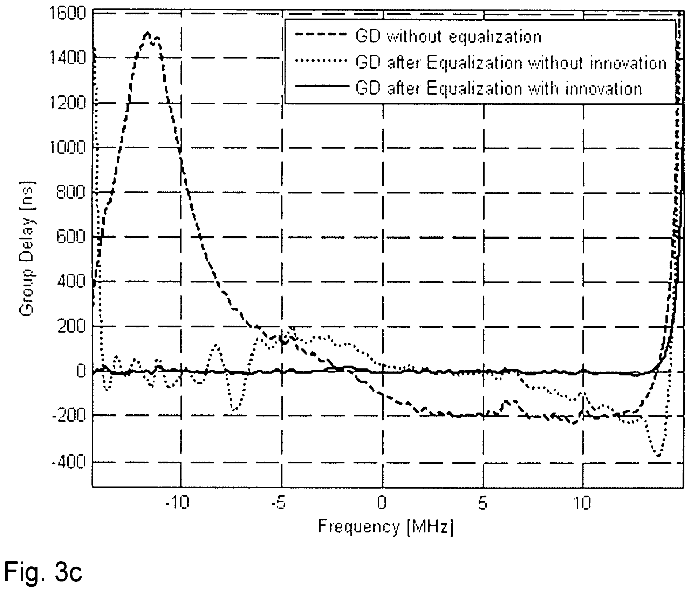

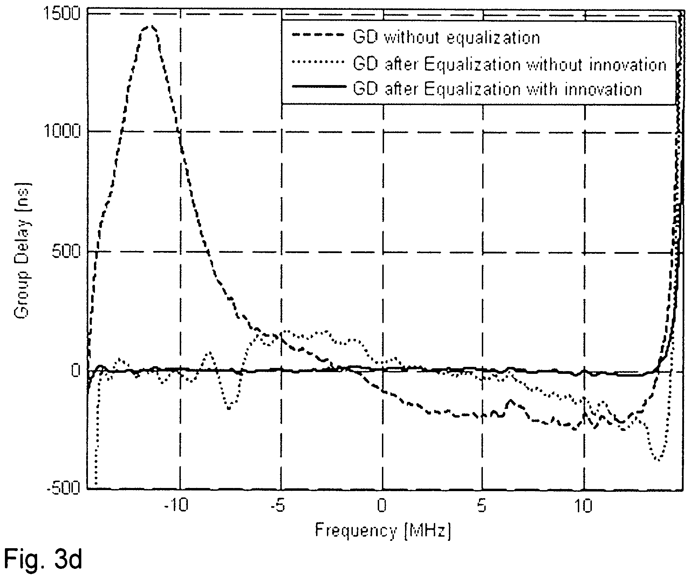

The performance of the FIR or IIR filter in the receiver 200 may be checked as follows: One way to show the performance of the FIR or IIR filter is to check that the group delay is constant after the decimation stage 118. If a CDMA signal is used, a very accurate way to check the performance of the FIR or IIR filter 114, 214 is to measure the symmetry of the cross-correlation function (i.e. correlation between the output (signal 250) of the decimation stage 218 and the reference signal). The symmetry is evaluated via a function name "S-curve bias" (discriminator-function (S-curve) of a non-coherent DLL). Examples are given in Figs. 3a to 3d.

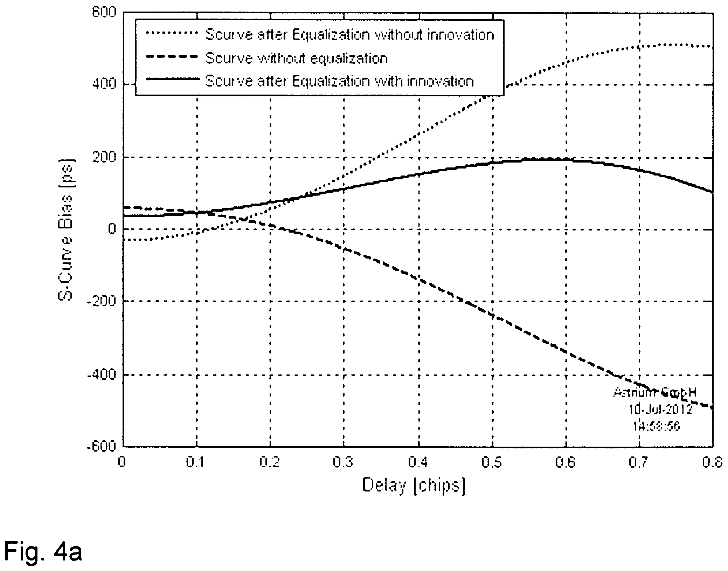

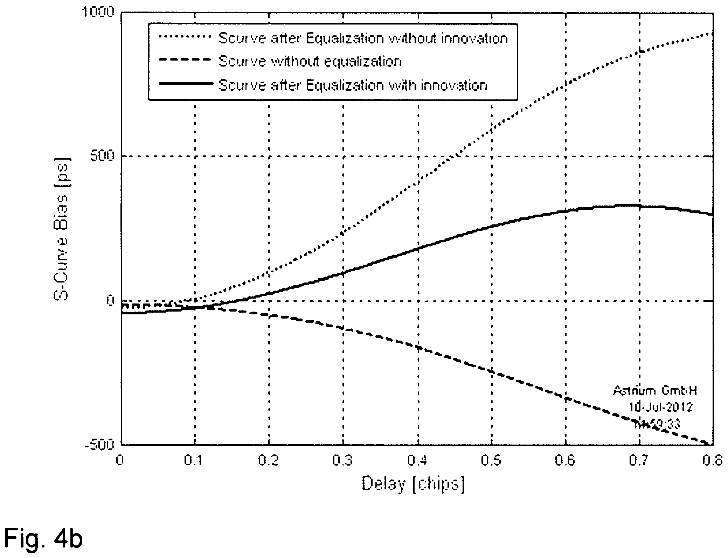

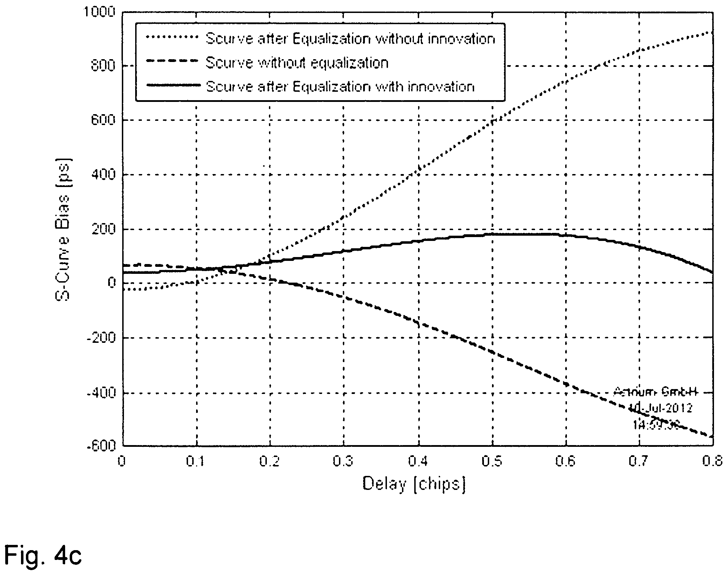

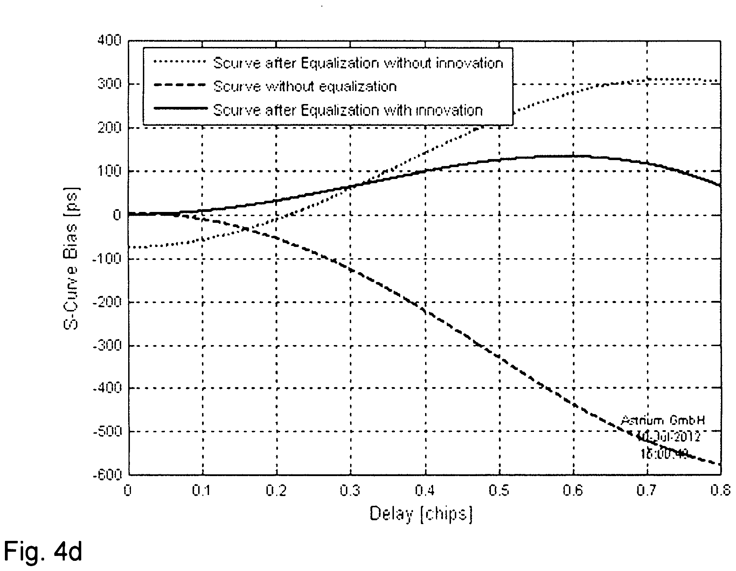

The performance of the FIR or IIR filter in the transmitter 100 may be checked as follows: In a transmitter, it is sometimes difficult to include the antenna 130 to measure directly a group delay. An anechoic chamber needs to be used. If a CDMA signal is used, a very accurate way to check the performance of the FIR or IIR filter 114 is to measure the symmetry of a cross-correlation function. For this purpose, the transmitter output filter signal needs to be digitized and converted to base-band using no RF filter or a very wide band filter to avoid including distortions inside the band. The antenna transfer characteristic is added artificially to the digitized signal. This digitized signal is then correlated with the reference signal: as for the receiver, the symmetry is evaluated via a function named "S-curve bias" (discriminator-function (S-curve) of a non-coherent DLL). Examples of a first to fourth scurve bias evaluation 1 to 4 are illustrated in Figs. 4a to 4d.

The advantage of this solution is a very accurate equalization method for the transmitted and the received signal with the help of a signal improving unit 110, 210. No particular constraints have to be imposed at the DAC or ADC as the sampling rate at the input or at the output is the same as for a conventional architecture for a transmitter or receiver.

### REFERENCE NUMERALS

- 100: transmitter
- 102: signal generation unit
- 110: signal improving unit
- 112: interpolation stage
- 114: FIR/IIR-filter
- 116: band pass filter
- 118: decimation stage
- 120: digital-analog converter (DAC)
- 122: High Power Amplifier (HPA)
- 124: analog output filter
- 130: antenna
- 150: transmitted signal

- 200: receiver
- 202: antenna
- 204: analog RF front end
- 206: analog-digital converter (ADC)
- 210: signal improving unit
- 212: interpolation stage
- 214: FIR/IIR-filter
- 216: band pass filter
- 218: decimation stage
- 240: received signal
- 250: digital signal to be processed

## Claims

1. A method for improving signal accuracy of a transmit signal to be transmitted by a transmitter (100), wherein the transmitter (100) comprises a signal improving unit (110) having a pre-distortion filter (114) followed by a chain of components having analog components of the transmitter (100), the method comprising the steps of:
a) evaluating a first transfer function of the amplitude and/or phase of the chain of components which has to be passed by the transmitted signal for a first bandwidth being broader than a useful transmitted bandwidth;
b) interpolating the first transfer function resulting in a modified first transfer function by multiplying a digital sampling frequency rate of the transmitted signal with an oversampling factor and extending the first transfer function artificially with zeros until an edge of the first bandwidth;
c) replacing the zeros of the modified first transfer function by a lowest absolute value to avoid any NaN, Not a Number, values by inversing the transfer function; and
d) evaluating first filter coefficients of the pre-distortion filter (114) of the signal improving unit (110) for equalizing the transmitted signal.

2. A method for improving signal accuracy of a receive signal to be received by a receiver (200), wherein the receiver (200) comprises a chain of components having analog components of the receiver (200) and a signal improving unit (210) having a post-distortion filter (214), said signal improving unit following said chain of components, the method comprising the steps of:
a) evaluating a second transfer function of the amplitude and/or phase of the chain of components which has to be passed by a received signal for a second bandwidth being broader than a useful received bandwidth;
b) interpolating the second transfer function resulting in a modified second transfer function by multiplying a digital sampling frequency rate of the received signal with an oversampling factor and extending the second transfer function artificially with zeros until an edge of the first bandwidth;
c) replacing the zeros of the modified second transfer function by a lowest absolute value to avoid any NaN, Not a Number, values by inversing the transfer function; and
d) evaluating second filter coefficients of the post-distortion filter (214) of the signal improving unit (210) for equalizing the received signal.

3. The method according to claim 1 or 2, wherein the first bandwidth and the second bandwidth, respectively, is twice wider than the useful transmitted bandwidth and the useful received bandwidth, respectively.

4. The method according to one of the preceding claims, wherein the first or second transfer function is evaluated by using a chirp signal.

5. The method according to one of the preceding claims, wherein equalization of the transmitted or the received signal is made at a base band with f_{IF} = 0.

6. The method according to one of the preceding claims, wherein for evaluating the first and second filter coefficients, respectively, the Gauss Newton algorithm is applied with which equalization is optimized for the useful transmitted or received bandwidth plus a margin bandwidth.

7. The method according to claim 6, wherein the phase of the inverse at a center frequency of the useful bandwidth is evaluated which is used as an input of the Gauss Newton algorithm.

8. The method according to one of the preceding claims, wherein the first and second filter coefficients, respectively, are evaluated for a digital sampling rate of the oversampling factor (K) multiplied with a digital sampling frequency (f_{S}) of the signal to be transmitted or received.

9. The method according to one of the preceding claims, wherein the
- the digital transmitted signal which is to be transmitted by the transmitter (100) is interpolated by a factor of K before being computed in the pre-distortion filter (114), and
- the digital received signal received by the receiver (200) is interpolated after an analog-digital-conversion before being computed in the post-distortion filter (214).

10. The method according to one of the preceding claims, wherein the output of pre- or post-distortion filter (214) is filtered with a bandpass-filter at the useful bandwidth to suppress a potential distortion due to the pre- or post-distortion filter (214).

11. The method according to one of the preceding claims, wherein each signal chain is equalized independently.

12. A computer program product directly loadable into the internal memory of a digital computer, comprising software code portions for performing the steps of claim 1 when said product is run on a computer.

13. A transmitter comprising a signal improving unit (110) having a pre-distortion filter (114) and a chain of components having analog components of the transmitter (100) following said signal improving unit, wherein the chain of components has a known first transfer function of the amplitude and/or phase of a transmit signal which passes the chain of components for a first bandwidth being broader than a useful transmitted bandwidth, further comprising:
a) a first means for interpolating the first transfer function resulting in a modified first transfer function by multiplying a digital sampling frequency rate of the transmitted signal with an oversampling factor and extending the first transfer function artificially with zeros until an edge of the first bandwidth;
b) a second means for replacing the zeros of the modified first transfer function by a lowest absolute value to avoid any NaN, Not a Number, values by inversing the transfer function; and
c) a third means for evaluating first filter coefficients of the pre-distortion filter (114) of the signal improving unit (110) for equalizing the transmitted signal.

14. A receiver (200) comprising a signal improving unit (210) having a chain of components having analogue components of the receiver (200), wherein the chain of components has a known second transfer function of the amplitude and/or phase of a receive signal which passes the chain of components for a second bandwidth being broader than a useful received bandwidth and a post-distortion filter (214), said post-distortion filter following said chain of components, further comprising:
a) a first means for interpolating the second transfer function resulting in a modified second transfer function by multiplying a digital sampling frequency rate of the received signal with an oversampling factor and extending the second transfer function artificially with zeros until an edge of the first bandwidth;
b) a second means for replacing the zeros of the modified second transfer function by a lowest absolute value to avoid any NaN, Not a Number, values by inversing the transfer function; and
c) a third means for evaluating second filter coefficients of the post-distortion filter (214) of the signal improving unit (210) for equalizing the received signal.

## Patentansprüche

1. Verfahren zur Verbesserung der Signalgenauigkeit eines Übertragungssignals, das von einem Sender (100) übertragen werden soll, wobei der Sender (100) eine Signalverbesserungseinheit (110) umfasst, die einen Vorverzerrungsfilter (114) aufweist, gefolgt von einer Komponentenkette, die analoge Komponenten des Senders (100) aufweist, das Verfahren umfassend die Schritte:
a) Bewerten einer ersten Übertragungsfunktion der Amplitude und/oder Phase der Komponentenkette, die von dem übertragenen Signal für eine erste Bandbreite, die größer ist als eine übertragene Nutzbandbreite, durchquert werden muss;
b) Interpolieren der ersten Übertragungsfunktion, die durch Multiplizieren einer digitalen Abtastfrequenzrate des übertragenen Signals mit einem Überabtastfaktor zu einer modifizierten ersten Übertragungsfunktion führt und die erste Übertragungsfunktion künstlich mit Nullen bis zu einem Rand der ersten Bandbreite ausdehnt;
c) Ersetzen der Nullen der modifizierten ersten Übertragungsfunktion durch einen niedrigsten absoluten Wert, um NaN-, Not A Number, Werte durch Umkehren der Übertragungsfunktion zu vermeiden; und
d) Bewerten erster Filterkoeffizienten des Vorverzerrungsfilters (114) der Signalverbesserungseinheit (110) zum Ausgleichen des übertragenen Signals.

2. Verfahren zur Verbesserung der Signalgenauigkeit eines Empfangssignals, das von einem Empfänger (200) empfangen werden soll, wobei der Empfänger (200) eine Komponentenkette, die analoge Komponenten des Empfängers (200) aufweist, und eine Signalverbesserungseinheit (210), die einen Nachverzerrungsfilter (214) aufweist, umfasst, wobei die Signalverbesserungseinheit nach der Komponentenkette angeordnet ist, das Verfahren umfassend die Schritte:
a) Bewerten einer zweiten Übertragungsfunktion der Amplitude und/oder Phase der Komponentenkette, die von einem empfangenen Signal für eine zweite Bandbreite, die größer ist als eine empfangene Nutzbandbreite, durchquert werden muss;
b) Interpolieren der zweiten Übertragungsfunktion, die durch Multiplizieren einer digitalen Abtastfrequenzrate des empfangenen Signals mit einem Überabtastfaktor zu einer modifizierten zweiten Übertragungsfunktion führt und die zweite Übertragungsfunktion künstlich mit Nullen bis zu einem Rand der ersten Bandbreite ausdehnt;
c) Ersetzen der Nullen der modifizierten zweiten Übertragungsfunktion durch einen niedrigsten absoluten Wert, um NaN-, Not A Number, Werte durch Umkehren der Übertragungsfunktion zu vermeiden; und
d) Bewerten zweiten Filterkoeffzienten des Nachverzerrungsfilters (214) der Signalverbesserungseinheit (210) zum Ausgleichen des empfangenen Signals.

3. Verfahren nach Anspruch 1 oder 2, wobei die erste Bandbreite beziehungsweise die zweite Bandbreite doppelt so breit ist wie die übertragene Nutzbandbreite beziehungsweise die empfangene Nutzbandbreite.

4. Verfahren nach einem der vorhergehenden Ansprüche, wobei die erste oder zweite Übertragungsfunktion unter Verwendung eines Chirp-Signals bewertet wird.

5. Verfahren nach einem der vorhergehenden Ansprüche, wobei ein Ausgleich des übertragenen oder des empfangenen Signals in einem Basisband mit f_{IF} = 0 erfolgt.

6. Verfahren nach einem der vorhergehenden Ansprüche, wobei zum Bewerten der ersten beziehungsweise zweiten Filterkoeffizienten der Gauß-Newton-Algorithmus angewendet wird, mit dem ein Ausgleich für die übertragene oder empfangene Nutzbandbreite plus einer Grenzbandbreite optimiert wird.

7. Verfahren nach Anspruch 6, wobei die Phase der Umkehrung bei einer Mittenfrequenz der Nutzbandbreite bewertet wird, die als Eingabe des Gauß-Newton-Algorithmus verwendet wird.

8. Verfahren nach einem der vorhergehenden Ansprüche, wobei die ersten beziehungsweise zweiten Filterkoeffizienten für eine digitale Abtastrate des Überabtastfaktors (K), der mit einer digitalen Abtastfrequenz (fs) des zu übertragenden oder empfangenden Signals multipliziert wird, bewertet werden.

9. Verfahren nach einem der vorhergehenden Ansprüche, wobei
- das übertragene digitale Signal, das von dem Sender (100) übertragen werden soll, durch einen Faktor K interpoliert wird, bevor es in dem Vorverzerrungsfilter (114) berechnet wird, und
- das empfangene digitale Signal, das von dem Empfänger (200) empfangen wird, nach einer Analog-Digital-Wandlung interpoliert wird, bevor es in dem Nachverzerrungsfilter (214) berechnet wird.

10. Verfahren nach einem der vorhergehenden Ansprüche, wobei die Ausgabe des Vor- oder Nachverzerrungsfilters (214) mit einem Bandpassfilter auf der Nutzbandbreite gefiltert wird, um eine mögliche Verzerrung aufgrund des Vor- oder Nachverzerrungsfilters (214) zu unterdrücken.

11. Verfahren nach einem der vorhergehenden Ansprüche, wobei jede Signalkette unabhängig ausgeglichen wird.

12. Computerprogrammprodukt, das direkt in den internen Speicher eines digitalen Computers ladbar ist, umfassend Softwarecodeabschnitte zum Durchführen der Schritte aus Anspruch 1, wenn das Produkt auf einem Computer ausgeführt wird.

13. Sender, umfassend eine Signalverbesserungseinheit (110), die einen Vorverzerrungsfilter (114) aufweist, und eine Komponentenkette, die analoge Komponenten des Senders (100) nach der Signalverbesserungseinheit aufweist, wobei die Komponentenkette eine bekannte erste Übertragungsfunktion der Amplitude und/oder Phase eines Übertragungssignals aufweist, das die Komponentenkette für eine erste Bandbreite, die größer ist als eine übertragene Nutzbandbreite, durchquert, ferner umfassend:
a) ein erstes Mittel zum Interpolieren der ersten Übertragungsfunktion, die durch Multiplizieren einer digitalen Abtastfrequenzrate des übertragenen Signals mit einem Überabtastfaktor zu einer modifizierten ersten Übertragungsfunktion führt und die erste Übertragungsfunktion künstlich mit Nullen bis zu einem Rand der ersten Bandbreite ausdehnt;
b) ein zweites Mittel zum Ersetzen der Nullen der modifizierten ersten Übertragungsfunktion durch einen niedrigsten absoluten Wert, um NaN-, Not A Number, Werte durch Umkehren der Übertragungsfunktion zu vermeiden; und
c) ein drittes Mittel zum Bewerten erster Filterkoeffizienten des Vorverzerrungsfilters (114) der Signalverbesserungseinheit (110) zum Ausgleichen des übertragenen Signals.

14. Empfänger (200), umfassend eine Signalverbesserungseinheit (210), die eine Komponentenkette aufweist, die analoge Komponenten des Empfängers (200) aufweist, wobei die Komponentenkette eine bekannte zweite Übertragungsfunktion der Amplitude und/oder Phase eines Empfangssignals, das die Komponentenkette für eine zweite Bandbreite, die größer ist als eine empfangene Nutzbandbreite, durchquert, und einen Nachverzerrungsfilter (214) aufweist, der Nachverzerrungsfilter nach der Komponentenkette ferner umfassend:
a) ein erstes Mittel zum Interpolieren der zweiten Übertragungsfunktion, die durch Multiplizieren einer digitalen Abtastfrequenzrate des empfangenen Signals mit einem Überabtastfaktor zu einer modifizierten zweiten Übertragungsfunktion führt und die zweite Übertragungsfunktion künstlich mit Nullen bis zu einem Rand der ersten Bandbreite ausdehnt;
b) ein zweites Mittel zum Ersetzen der Nullen der modifizierten zweiten Übertragungsfunktion durch einen niedrigsten absoluten Wert, um NaN-, Not A Number, Werte durch Umkehren der Übertragungsfunktion zu vermeiden; und
c) ein drittes Mittel zum Bewerten zweiter Filterkoeffizienten des Vorverzerrungsfilters (214) der Signalverbesserungseinheit (210) zum Ausgleichen des empfangenen Signals.

## Revendications

1. Procédé pour améliorer la précision de signal d'un signal d'émission à émettre par un émetteur (100), dans lequel l'émetteur (100) comprend une unité d'amélioration de signal (110) ayant un filtre de pré-distorsion (114) suivie d'une chaîne de composants ayant des composants analogiques de l'émetteur (100), le procédé comprenant les étapes consistant à :
a) évaluer une première fonction de transfert de l'amplitude et/ou de la phase de la chaîne de composants qui doit être traversée par le signal émis pour une première bande passante qui est plus large qu'une bande passante émise utile ;
b) interpoler la première fonction de transfert conduisant à une première fonction de transfert modifiée par multiplication d'un taux de fréquence d'échantillonnage numérique du signal émis avec un facteur de sur-échantillonnage et extension de la première fonction de transfert artificiellement avec des zéros jusqu'à un bord de la première bande passante ;
c) remplacer les zéros de la première fonction de transfert modifiée par une valeur absolue la plus faible pour empêcher de quelconques valeurs NaN, Non un Nombre, par inversion de la fonction de transfert ; et
d) évaluer des premiers coefficients de filtre du filtre de pré-distorsion (114) de l'unité d'amélioration de signal (110) pour égaliser le signal émis.

2. Procédé pour améliorer la précision de signal d'un signal de réception à recevoir par un récepteur (200), dans lequel le récepteur (200) comprend une chaîne de composants ayant des composants analogiques du récepteur (200) et une unité d'amélioration de signal (210) ayant un filtre de post-distorsion (214), ladite unité d'amélioration de signal suivant ladite chaîne de composants, le procédé comprenant les étapes consistant à :
a) évaluer une seconde fonction de transfert de l'amplitude et/ou de la phase de la chaîne de composants qui doit être traversée par un signal reçu pour une seconde bande passante qui est plus large qu'une bande passante reçue utile ;
b) interpoler la seconde fonction de transfert conduisant à une seconde fonction de transfert modifiée par multiplication d'un taux de fréquence d'échantillonnage numérique du signal reçu avec un facteur de sur-échantillonnage et extension de la seconde fonction de transfert artificiellement avec des zéros jusqu'à un bord de la première bande passante ;
c) remplacer les zéros de la seconde fonction de transfert modifiée par une valeur absolue la plus faible pour empêcher de quelconques valeurs NaN, Non un Nombre, par inversion de la fonction de transfert ; et
d) évaluer des seconds coefficients de filtre du filtre de post-distorsion (214) de l'unité d'amélioration de signal (210) pour égaliser le signal reçu.

3. Procédé selon la revendication 1 ou 2, dans lequel la première bande passante et la seconde bande passante, respectivement, sont deux fois plus larges que la bande passante émise utile et la bande passante reçue utile, respectivement.

4. Procédé selon l'une des revendications précédentes, dans lequel la première ou seconde fonction de transfert est évaluée par utilisation d'un signal de piaulement.

5. Procédé selon l'une des revendications précédentes, dans lequel une égalisation du signal émis ou du signal reçu est réalisée au niveau d'une bande de base avec f_{IF} = 0.

6. Procédé selon l'une des revendications précédentes, dans lequel, pour évaluer les premiers et seconds coefficients de filtre, respectivement, l'algorithme de Gauss Newton est appliqué avec lequel une égalisation est optimisée pour la bande passante émise ou reçue utile plus une bande passante de marge.

7. Procédé selon la revendication 6, dans lequel la phase de l'inverse au niveau d'une fréquence centrale de la bande passante utile est évaluée qui est utilisée en tant qu'entrée de l'algorithme de Gauss Newton.

8. Procédé selon l'une des revendications précédentes, dans lequel les premiers et seconds coefficients de filtre, respectivement, sont évalués pour un taux d'échantillonnage numérique du facteur de sur-échantillonnage (K) multiplié avec une fréquence d'échantillonnage numérique (f_{S}) du signal à émettre ou recevoir.

9. Procédé selon l'une des revendications précédentes, dans lequel
- le signal émis numérique qui doit être émis par l'émetteur (100) est interpolé par un facteur de K avant d'être calculé dans le filtre de pré-distorsion (114), et
- le signal reçu numérique reçu par le récepteur (200) est interpolé après une conversion analogique-numérique avant d'être calculé dans le filtre post-distorsion (214).

10. Procédé selon l'une des revendications précédentes, dans lequel la sortie du filtre de pré- ou post-distorsion (214) est filtrée avec un filtre passe-bande au niveau de la bande passante utile pour supprimer une distorsion potentielle due au filtre de pré- ou post-distorsion (214).

11. Procédé selon l'une des revendications précédentes, dans lequel chaque chaîne de signal est égalisée indépendamment.

12. Produit programme d'ordinateur directement chargeable dans la mémoire interne d'un ordinateur numérique, comprenant des parties de code de logiciel pour réaliser les étapes de la revendication 1 lorsque ledit produit est exécuté sur un ordinateur.

13. Emetteur comprenant une unité d'amélioration de signal (110) ayant un filtre de pré-distorsion (114) et une chaîne de composants ayant des composants analogiques de l'émetteur (100) suivant ladite unité d'amélioration de signal, dans lequel la chaîne de composants possède une première fonction de transfert connue de l'amplitude et/ou de la phase d'un signal d'émission qui traverse la chaîne de composants pour une première bande passante qui est plus large qu'une bande passante émise utile, comprenant en outre :
a) un premier moyen pour interpoler la première fonction de transfert conduisant à une première fonction de transfert modifiée par multiplication d'un taux de fréquence d'échantillonnage numérique du signal émis avec un facteur de sur-échantillonnage et extension de la première fonction de transfert artificiellement avec des zéros jusqu'à un bord de la première bande passante ;
b) un second moyen pour remplacer les zéros de la première fonction de transfert modifiée par une valeur absolue la plus faible pour empêcher de quelconques valeurs NaN, Non un Nombre, par inversion de la fonction de transfert ; et
c) un troisième moyen pour évaluer des premiers coefficients de filtre du filtre de pré-distorsion (114) de l'unité d'amélioration de signal (110) pour égaliser le signal émis.

14. Récepteur (200) comprenant une unité d'amélioration de signal (210) ayant une chaîne de composants ayant des composants analogiques du récepteur (200), dans lequel la chaîne de composants possède une seconde fonction de transfert connue de l'amplitude et/ou de la phase du signal de réception qui traverse la chaîne de composants pour une seconde bande passante qui est plus large qu'une bande passante reçue utile et un filtre de post-distorsion (214), ledit filtre de post-distorsion suivant ladite chaîne de composants, comprenant en outre :
a) un premier moyen pour interpoler la seconde fonction de transfert conduisant à une seconde fonction de transfert modifiée par multiplication d'un taux de fréquence d'échantillonnage numérique du signal reçu avec un facteur de sur-échantillonnage et extension de la seconde fonction de transfert artificiellement avec des zéros jusqu'à un bord de la première bande passante ;
b) un second moyen pour remplacer les zéros de la seconde fonction de transfert modifiée par une valeur absolue la plus faible pour empêcher de quelconques valeurs NaN, Non un Nombre, par inversion de la fonction de transfert ; et
c) un troisième moyen pour évaluer des seconds coefficients de filtre du filtre de post-distorsion (214) de l'unité d'amélioration de signal (210) pour égaliser le signal reçu.
